# EUROPÄISCHE PATENTSCHRIFT

(11) **EP 2 043 781 B1**
(45) Veröffentlichungstag und Bekanntmachung des Hinweises auf die Patenterteilung: **07.09.2011**
(21) Anmeldenummer: 07787722.3
(22) Anmeldetag: 19.07.2007
(51) Int. Cl.: B01J 35/00, C23C 14/04, C23C 16/04, B62B 1/00, B62B 3/00, B81C 1/00

(54) **ANORDNUNG MIT NANOTEILCHEN UND VERFAHREN ZU DEREN HERSTELLUNG**
ARRANGEMENT COMPRISING NANOPARTICLES, AND METHOD FOR THE PRODUCTION THEREOF
ENSEMBLE COMPORTANT DES NANOPARTICULES ET PROCÉDÉ DE RÉALISATION ASSOCIÉ

(30) Priorität: 21.07.2006 DE 102006033866
(43) Veröffentlichungstag der Anmeldung: 08.04.2009
(73) Patentinhaber: SIEMENS AKTIENGESELLSCHAFT, 80333 München (DE)
(72) Erfinder: ARNDT, Frank, 13581 Berlin (DE); HOLST, Jens-Christian, 14057 Berlin (DE); JENSEN, Jens Dahl, 14050 Berlin (DE); KRÜGER, Ursus, 14089 Berlin (DE)
(86) Internationale Anmeldenummer: PCT/EP2007/057464
(87) Internationale Veröffentlichungsnummer: WO 2008/009716

(56) Entgegenhaltungen:
- WO-A-03/095111
- US-A1- 2003 077 625
- US-A1- 2005 061 451
- US-A1- 2006 154 380
- US-B1- 6 964 936
- HULTEEN J.C., TREICHEL D.A., SMITH M.T., DUVAL M.L., JENSEN T.R., VAN DUYNE R.P.: "Nanosphere Lithography: Size-tunable silver nanoparticles and surface cluster arrays" JOURNAL OF PHYSICAL CHEMISTRY B., Bd. 103, 1999, Seiten 3854-3863, XP002454326
- JUNG J., KIM K.W., NA K., KAHOLEK M., ZAUSCHER S., HYUN J.: "Fabrication of Micropatterned Gold Nanoparticle Arrays as a template for surface-initiated Polymerization of Stimuli-responsive Polymers" MACROMOLECULAR RAPID COMMUNICATIONS, Bd. 27, 19. Mai 2006 (2006-05-19), Seiten 776-780, XP002454327
- MISNER M.J., SKAFF H., EMRICK T., RUSSELL T.P.: "Directed Deposition of Nanoparticles Using diblock copolymer templates" ADVANCED MATERIALS, Bd. 15, Nr. 3, 2003, Seiten 221-224, XP002454328
- SOHN B-H., CHOI J-M., YOO S.I., YUN S-H., ZIN W-C., JUNG J C., KANEHARA M., HIRATA T., TERANISHI T.: "Directed self assembly of two kinds of Nanoparticles utilizing Monolayer Films of diblocks Copolymer micelles" JOURNAL OF THE AMERICAN CHEMICAL SOCIETY, Bd. 125, 2003, Seiten 6368-6369, XP002454329
- HAES A.J., STUART D.A., NIE S., VAN DUYNE R.P.: "Using Solution-phase nanoparticles , surface -confined nanoparticles arrays and single nanoparticles as biologicla sensing platforms" JOURNAL OF FLUORESCENCE, Bd. 14, Nr. 4, 2004, Seiten 355-367, XP002454330

## Beschreibung

Die Erfindung bezieht sich auf eine Anordnung mit Nanoteilchen bzw. Nanopartikeln, wobei auf einer Trägeroberfläche eines Trägers beabstandet zueinander zumindest zwei Arten von Nanoteilchen angeordnet sind, die jeweils beide aus einem Metallmaterial bestehen und die sich bezüglich des Metallmaterials unterscheiden, wobei die beiden Metallmaterialien unterschiedlich edel sind bzw. unterschiedliche Redoxpotentiale aufweisen.

Unter dem Begriff "Nanoteilchen" bzw. "Nanopartikel" sind in diesem Zusammenhang Partikel bzw. Teilchen zu verstehen, die eine Partikelgröße von unter einem Mikrometer - in zumindest einer räumlichen Ausdehnung - aufweisen. Bekanntermaßen können Nanoteilchen bzw. -partikel in unterschiedlichen Bereichen der Technik eingesetzt werden. Beispielsweise ist in der internationalen Offenlegungsschrift WO 03/095111 A1 beschrieben, dass Nanopartikel in Array-Strukturen angeordnet werden können. B.-H. Sohn et al. haben im Journal of the American Chemical Society, Volume 25, 2003, Seiten 6368 bis 6369 beschrieben, dass ein Selbstorganisationsprozess von Partikeln zweier Arten auch ausgelöst werden kann, indem diese mit unterschiedlichen Polymeren gemantelt werden. Die Polymere bilden um die verwendeten Nanopartikel Mizellen, die zu einem Selbstorganisationsprozess zwischen den Nanopartikeln beitragen. Hierbei entsteht eine einzelne Lage von Nanopartikeln auf der zu beschichtenden Oberfläche, wobei die Nanopartikel jeweils in einem Abstand von ungefähr 50 nm zueinander angeordnet sind.

Der Erfindung liegt die Aufgabe zugrunde, eine Anordnung anzugeben, die über ihren Nanoteilchencharakter hinaus noch weitere Eigenschaften besitzt und sich damit für noch weitere Einsatzmöglichkeiten qualifiziert.

Diese Aufgabe wird erfindungsgemäß durch eine Anordnung mit den Merkmalen gemäß Patentanspruch 1 und durch ein Verfahren zum Herstellen einer Nanoteilchen aufweisenden Anordnung mit den Merkmalen gemäß Patentanspruch 5 gelöst. Vorteilhafte Ausgestaltungen der erfindungsgemäßen Anordnung sind in Unteransprüchen angegeben.

Danach ist erfindungsgemäß vorgesehen, dass der Abstand zwischen den beiden Nanoteilchen vorzugsweise derart eingestellt ist, dass die beiden Nanoteilchen in einem Elektrolyten eine galvanische Zelle bilden können. Ein Abstand zwischen den beiden Nanoteilchen von 5 µm bis 10 µm wird als notwendig angesehen. Im Hinblick auf einen möglichst kompakten Aufbau der Anordnung ist erfindungsgemäß überdies vorgesehen, dass eine Vielzahl an Nanoteilchen schachbrettmusterartig, beispielsweise auf einer ebenen oder planen Trägeroberfläche, derart angeordnet ist, dass jedes Nanoteilchen einer Art von vier Nanoteilchen der jeweils anderen Art umgeben wird. Bei einer solchen Positionierung der Nanoteilchen lässt sich eine sehr große Dichte an galvanischen Zellen pro Flächeneinheit der Trägeroberfläche erreichen.

Ein wesentlicher Vorteil der erfindungsgemäßen Anordnung ist darin zu sehen, dass die Nanoteilchen aufgrund der unterschiedlichen Edelkeit bzw. der unterschiedlichen Redoxpotentiale der Metallmaterialien noch weitere chemische Eigenschaften aufweisen können: Beispielsweise können sie eine galvanische Zelle bilden, sobald sie mit einem Elektrolyten in Kontakt gebracht werden. Durch die Fähigkeit, eine galvanische Zelle zu bilden, kann die Anordnung beispielsweise auf unterschiedlichen technischen Gebieten, beispielsweise im medizinischen Bereich, genutzt werden. Zum Beispiel kann die Anordnung eine antibakterielle Wirkung zeigen, wenn es im Zusammenwirken mit einem Elektrolyten zu einem Stromfluss zwischen den Nanoteilchen kommt. Abgesehen von einem Einsatz im medizinischen Bereich eignet sich die Anordnung aufgrund ihrer elektrochemischen Eigenschaften auch für andere Anwendungen, beispielsweise für die Innenbeschichtung von Kondensatorrohren, Wärmetauschern oder dergleichen. Auch ein Lotusblüteneffekt oder katalytische Wirkungen kann die Anordnung bei geeigneter Wahl der Materialien zeigen.

Im Hinblick auf eine einfache Herstellung der Anordnung wird es als vorteilhaft angesehen, wenn die Trägeroberfläche zumindest abschnittsweise plan bzw. eben ist; in diesem Falle können die Nanopartikel in derselben Ebene, zumindest näherungsweise räumlich in derselben Ebene, liegen.

Die beiden metallischen Materialien werden vorzugsweise durch Reinstoffe wie chemische Elemente oder Metalllegierungen gebildet.

Um einen elektrischen Kurzschluss zwischen den Nanoteilchen zu vermeiden, wird es als vorteilhaft angesehen, wenn der Träger aus einem elektrisch nichtleitenden oder einem elektrisch schlechtleitenden Material besteht.

Wird die Anordnung im Rahmen medizinischer Verfahren im menschlichen oder tierischen Körper eingesetzt, so wird es als vorteilhaft angesehen, wenn die Abgabe von Metallionen minimiert wird; denn freigesetzte Metallionen im menschlichen oder tierischen Körper können bei zu hoher Konzentration unter Umständen Schädigungen hervorrufen. Eine Ionenabgabe kann reduziert, zumindest deutlich verlangsamt werden, wenn der Unterschied der Redoxpotentiale zwischen den Materialien der beiden Nanoteilchen möglichst klein ist. Vorzugsweise werden die beiden metallischen Materialien so gewählt, dass die Differenz der Redoxpotentiale kleiner als 200 mV ist. Die Differenz der Redoxpotentiale entspricht der thermodynamisch treibenden Kraft für die Ionenabgabe. Die Ionenabgabe wird aber auch durch die kinetischen Eigenschaften der Oberfläche bestimmt, die das chemische Verhalten der Nanopartikel beeinflussen.

Für den Einsatz der Anordnung als antibakterieller "Wirkstoff" im menschlichen oder tierischen Körper wird es als vorteilhaft angesehen, wenn das unedlere metallische Material der beiden Nanoteilchen durch Silber gebildet wird; denn Silber wirkt antibakteriell, insbesondere dann, wenn es zusammen mit Chlorionen eines Elektrolyten eine Silber-Chlorid-Schicht auf dem aus Silber bestehenden Partikel bildet.

Um eine Abgabe von Silberionen in den menschlichen Körper zu vermeiden, sollte das andere metallische Material vorzugsweise nicht viel edler als Silber sein. Ein geeignetes Partnermaterial für Silber ist beispielsweise Palladium, das ein Redoxpotential von 0,92 V aufweist. Da Silber ein Redoxpotential von 0,8 V aufweist, ist die Differenz der beiden Redoxpotentiale mit ca. 120 mV relativ gering, so dass ein Austreten von Silberionen aus dem Silber-Partikel sehr langsam erfolgt und/oder zumindest für eine gewisse Zeitspanne unterbunden wird, wenn sich auf dem Silber-Partikel eine Silber-Chlorid-Schicht ausbilden kann.

Die Erfindung bezieht sich darüber hinaus auf ein Verfahren zum Herstellen einer Nanoteilchen aufweisenden Anordnung, bei dem auf einer Trägeroberfläche eines Trägers beabstandet zueinander zumindest zwei Arten von Nanoteilchen aufgebracht werden, die jeweils beide aus einem Metallmaterial bestehen und die sich bezüglich des Metallmaterials unterscheiden, wobei die beiden Metallmaterialien unterschiedlich edel sind.

Wie bereits erläutert, wird erfindungsgemäß der Abstand zwischen den beiden Nanoteilchen vorzugsweise derart eingestellt, dass die beiden Nanoteilchen in einem Elektrolyten eine galvanische Zelle bilden können. Erfindungsgemäß wird überdies auf der Trägeroberfläche eine Vielzahl an Nanoteilchen aufgebracht, und zwar zumindest zwei Arten von Nanoteilchen, die aus unterschiedlich edlen Metallmaterialien bestehen. Neben jedem Nanoteilchen wird jeweils zumindest ein Nanoteilchen der jeweils anderen Art unmittelbar benachbart angeordnet.

Im Hinblick auf die Ausbildung von galvanischen Zellen wird es als notwendig angesehen, wenn der Abstand zwischen jedem Nanoteilchen der einen Art und dem unmittelbar benachbarten Nanoteilchen der jeweils anderen Art zwischen 5 µm bis 10 µm beträgt.

Bezüglich der Vorteile des Verfahrens, die sich aus der unterschiedlichen Edelkeit der beiden Metallmaterialien ergeben, sei auf die obigen Ausführungen im Zusammenhang mit der erfindungsgemäßen Anordnung verwiesen.

Um zu vermeiden, dass der Träger eine Ausbildung von galvanischen Zellen zwischen den Nanoteilchen verhindert oder erschwert, wird es als vorteilhaft angesehen, wenn als Trägermaterial ein elektrisch nichtleitendes oder ein elektrisch schlechtleitendes Material verwendet wird.

Wie bereits erwähnt, wird bevorzugt als das unedlere Metallmaterial Silber oder ein Silber enthaltendes Material verwendet. Als das edlere Metallmaterial wird vorzugsweise Palladium, Platin, Rhodium und/oder Ruthenium oder ein Material, das dieses oder mehrere dieser Metalle enthält, verwendet.

Gemäß einer besonders bevorzugten Variante wird es als vorteilhaft angesehen, wenn eine erste Lochmaske mit einer vorgegebenen ersten Lochanordnung auf der Trägeroberfläche des Trägers aufgebracht wird, Nanoteilchen aus einem ersten Metallmaterial in den durch die Lochanordnung vorgegebenen Positionen auf der Trägeroberfläche befestigt werden, eine zweite Lochmaske mit einer vorgegebenen zweiten Lochanordnung auf der Trägeroberfläche aufgebracht wird und Nanoteilchen aus einem zweiten Metallmaterial in den durch die Lochanordnung der zweiten Lochmaske vorgegebenen Positionen auf der Trägeroberfläche befestigt werden.

Beispielsweise werden die Nanoteilchen aus dem ersten Metallmaterial in den Löchern der ersten Lochmaske gebildet, indem das erste Metallmaterial im Bereich der Löcher auf der Trägeroberfläche abgeschieden, insbesondere aufgewachsen, wird, und/oder es werden die Nanoteilchen aus dem zweiten Metallmaterial in den Löchern der zweiten Lochmaske gebildet, indem das zweite Metallmaterial im Bereich der Löcher auf der Trägeroberfläche abgeschieden, insbesondere aufgewachsen, wird.

Ein Aufwachsen kann beispielsweise galvanisch in einem galvanischen Bad erfolgen.

Alternativ können fertige Nanoteilchen aus dem ersten Metallmaterial in die Löcher der ersten Lochmaske eingeführt und auf der Trägeroberfläche befestigt werden und/oder fertige Nanoteilchen aus dem zweiten Metallmaterial in die Löcher der zweiten Lochmaske eingeführt und auf der Trägeroberfläche befestigt werden.

Gemäß einer anderen bevorzugten Variante wird es als vorteilhaft angesehen, wenn auf der Trägeroberfläche eine Hilfsschicht aufgebracht wird, die für jede der zumindest zwei Arten von Nanoteilchen jeweils chemische Ankoppelstellen bereitstellt, an denen die Nanoteilchen chemisch ankoppeln können, wobei die Ankoppelstellen beabstandet zueinander sind, eine Mischung aus fertigen Nanoteilchen aus zumindest zwei unterschiedlich edlen Metallmaterialien auf der mit der Hilfsschicht versehenen Trägeroberfläche aufgebracht wird und eine durch die Anordnung der Ankoppelstellen auf der Hilfsschicht vorgegebene Nanoteilchenverteilung auf dem Träger erreicht wird.

Beispielsweise wird die Hilfsschicht gebildet, indem auf der Trägeroberfläche eine Polymerschicht mit einer Molekülstruktur aufgetragen wird, die für jede der zwei Arten von Nanoteilchen jeweils zumindest eine Ankoppelstelle bereitstellt.

Alternativ kann die Hilfsschicht gebildet werden, indem auf der Trägeroberfläche ein sich vernetzendes Material mit selbst organisierenden Molekülen aufgebracht wird, die jeweils zumindest eine Ankoppelstelle bereitstellen.

Im Hinblick auf eine maximale Dichte an galvanischen Zellen pro Flächeneinheit wird es als vorteilhaft angesehen, wenn die Vielzahl an Nanoteilchen schachbrettmusterartig derart angeordnet wird, dass jedes Nanoteilchen einer Art von vier Nanoteilchen der jeweils anderen Art umgeben wird.

Gemäß einer wiederum anderen bevorzugten Variante wird es als vorteilhaft angesehen, wenn eine Mischung aus fertigen Nanoteilchen aus zumindest zwei unterschiedlich edlen Metallmaterialien auf einem mit einer Lochmaske versehenen Träger aufgebracht wird und eine durch die Stöchiometrie vorgegebene, zufällige bzw. stochastische Nanoteilchenverteilung auf dem Träger erreicht wird.

Die Erfindung wird nachfolgend anhand verschiedener Ausführungsbeispiele näher erläutert; dabei zeigen beispielhaft
- Figuren 1-6: ein erstes Ausführungsbeispiel für ein erfin- dungsgemäßes Verfahren zum Herstellen eines Ausführungsbeispiels einer erfindungsgemäßen Anordnung bzw. Struktur, wobei zwei Lochmasken verwendet werden,
- Figuren 7-11: ein zweites Ausführungsbeispiel für ein erfin- dungsgemäßes Verfahren zum Herstellen eines Ausführungsbeispiels einer erfindungsgemäßen Anordnung bzw. Struktur, wobei nur eine Loch- maske verwendet wird,
- Figur 12: ein drittes Ausführungsbeispiel für ein erfin- dungsgemäßes Verfahren zum Herstellen eines Ausführungsbeispiels einer erfindungsgemäßen Anordnung bzw. Struktur, wobei eine Hilfs- schicht verwendet wird, und
- Figur 13: ein viertes Ausführungsbeispiel für ein erfin- dungsgemäßes Verfahren zum Herstellen eines Ausführungsbeispiels einer erfindungsgemäßen Anordnung bzw. Struktur, wobei eine andere Art Hilfsschicht als bei Figur 12 verwendet wird.

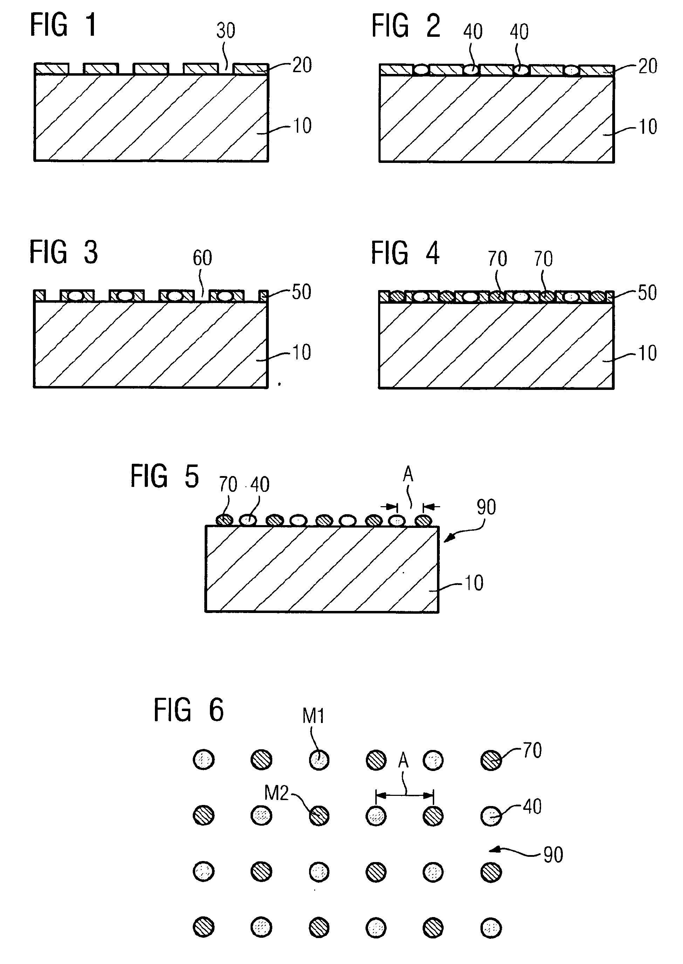

In den Figuren 1 bis 13 werden für identische bzw. vergleichbare Komponenten der Übersichtlichkeit halber identische Bezugszeichen verwendet.

Im Zusammenhang mit den Figuren 1 bis 6 wird nun ein erstes Ausführungsbeispiel eines Verfahrens zur Herstellung einer Anordnung mit Nanoteilchen erläutert.

In der Figur 1 erkennt man einen Träger 10, auf dem eine erste Fotomaske 20 aufgetragen ist. Die Fotomaske 20 ist bereits strukturiert und weist Löcher 30 auf; die Fotomaske 20 bildet somit also eine Lochmaske. Das Strukturieren der Fotomaske 20 kann auf übliche Weise durchgeführt werden, beispielsweise durch eine Elektronenstrahlstrukturierung, eine Laserstrukturierung oder eine sonstige optische Strukturierung.

Auf dem in dieser Weise beschichteten Träger 10 werden nun Nanoteilchen 40 aufgewachsen, in dem ein erstes Metallmaterial M1 auf den Träger 10 aufgebracht wird. Das Aufwachsen der Nanoteilchen 40 kann in beliebiger Weise erfolgen, beispielsweise im Rahmen eines Aufdampf- (z. B. CVD-Schritt) oder eines Sputterschritts. Darüber hinaus kann das Abscheiden des Metallmaterials M1 magnetisch oder elektrostatisch unterstützt werden. Auch ist das Abscheiden des Metallmaterials M1 auf elektrochemischem Wege möglich, beispielsweise in einem galvanischen Bad im Rahmen eines "Electroforming"-Schritts.

Die mit den Nanoteilchen 40 versehene Struktur ist in der Figur 2 dargestellt; die erste Fotomaske 20 ist dabei noch vorhanden.

Nach dem Abscheiden der Nanoteilchen 40 wird die erste Fotomaske 20 vollständig entfernt, und es wird nachfolgend eine zweite Fotomaske 50 aufgetragen. Die zweite Fotomaske 50 wird ebenfalls strukturiert, so dass Löcher 60 gebildet werden. Bei dem Aufbringen der zweiten Foto- bzw. Lochmaske 50 werden die bereits in dem vorhergehenden Schritt abgeschiedenen Nanoteilchen 40 in die zweite Fotomaske 50 eingebettet; dies ist schematisch in der Figur 3 dargestellt.

Im Rahmen eines zweiten Abscheidungsschritts werden nun Nanoteilchen 70 aus einem zweiten Metallmaterial M2 abgeschieden; diese Nanoteilchen 70 bilden daher eine andere Nanoteilchenart. Das Aufwachsen des zweiten Metallmaterials M2 erfolgt dabei in vergleichbarer Weise wie das Aufwachsen des ersten Metallmaterials M1, also beispielsweise so, wie dies im Zusammenhang mit der Figur 2 erläutert worden ist. Die resultierende Struktur ist in der Figur 4 dargestellt.

Nach dem Ablösen der zweiten Lochmaske 50 ist nun eine Anordnung 90 fertig gestellt, bei der auf dem Träger 10 Nanoteilchen 40 aus einem ersten Metallmaterial M1 und Nanoteilchen 70 aus einem zweiten Metallmaterial M2 aufgebracht sind. Der Abstand zwischen Nanoteilchen unterschiedlichen Metallmaterials ist in der Figur 5 mit dem Bezugszeichen A gekennzeichnet. Der Abstand A beträgt vorzugsweise ca. 5 bis 10 µm.

Die beiden Materialien M1 und M2 sind derart gewählt, dass sich die Redoxpotentiale der beiden Materialien M1 und M2 unterscheiden. Nachfolgend wird beispielhaft davon ausgegangen, dass es sich bei dem ersten Material M1 der Nanoteilchen 40 um ein gegenüber dem zweiten Material M2 der Nanoteilchen 70 unedleres Metall bzw. um eine unedlere Metalllegierung handelt.

Die Eigenschaft eines Metalls edel oder unedel zu sein, ergibt sich aus dem jeweiligen Redoxpotential bzw. der elektrochemischen Spannungsreihe; die nachfolgende beispielhafte und nicht abschließend gemeinte Liste mit für Nanopartikel geeigneten Metallen ist von unedel nach edel bzw. im Hinblick auf ansteigende Redoxpotentiale (Redoxpotential gegen Standard-Wasserstoffelektrode bei 25°C) sortiert:

| | |
|---|---|
| Lithium | -3 V |
| Magnesium | -2,4 V |
| Aluminium | -1,7 V |
| Zink | -0,8V |
| Silber | +0,8 V |
| Palladium | +0,9 V |

Ein insbesondere im Hinblick auf medizinische Anwendungen sehr geeignetes Material ist beispielsweise Silber, da Silber bzw. Silber-Ionen antibakteriell wirken. Demgemäß wird nachfolgend beispielhaft davon ausgegangen, dass Silber als das erste unedle Material M1 verwendet wird; denn das unedlere Material einer galvanischen Zelle kann in einem Elektrolyten Ionen nach außen abgegeben werden.

Bei dem zweiten Material M2 der Nanoteilchen 70 handelt es sich demgemäß um ein edleres Metall, beispielsweise um Gold oder.Palladium. Palladium besitzt ein Redoxpotential von 0,92 V, das dem des Silbers relativ ähnlich ist, so dass die Differenz D der Redoxpotentiale zwischen den beiden Materialien M1 (Silber) und M2 (Palladium) also nur D = 120 mV beträgt.

Wird die Struktur 90 gemäß Figur 5 mit einem Elektrolyten in Kontakt gebracht, indem es beispielsweise in den menschlichen Körper eingeführt wird, so wird das Silbermaterial M1 mit Chlorionen des Elektrolyten, die in Körper- bzw. Zellflüssigkeiten des menschlichen Körpers stets vorhanden sind, reagieren, so dass sich auf den Nanoteilchen 40 eine chemisch hochstabile Silber-Chlorid-Schicht bilden wird. Diese Silber-Chlorid-Schicht wird die Oberfläche der Nanoteilchen 40 von dem Elektrolyten trennen, so dass eine unmittelbare Abgabe von Silberionen aus den Nanoteilchen 40 in den Elektrolyten hinein verhindert, zumindest jedoch stark verlangsamt wird. Durch die Bildung der Silber-Chlorid-Schicht auf der Oberfläche der Nanoteilchen 40 wird somit sichergestellt, dass es zu keiner unzulässig hohen Abgabe von Silberionen in den menschlichen Körper kommen kann. Trotzdem wird eine antibakterielle Wirkung erzielt, da die Silber-Chlorid-Schicht selbst bakterizid wirkt.

Anstelle der beschriebenen Materialkombination Silber/Palladium können auch andere Materialkombinationen, insbesondere auf der Basis von Silber, verwendet werden, um eine antibakterielle Wirkung zu entfalten: Andere geeignete Materialkombinationen sind beispielsweise Silber-Platin, Silber-Ruthenium und Silber-Rhodium.

Bei der Materialwahl sollte vorzugsweise beachtet werden, dass im Falle einer Verwendung von Silber das unedle Material der beiden Materialien M1 und M2 durch das Silber gebildet wird, damit es Ionen erzeugen und/oder die beschriebene Silber-Chloridschicht bilden kann. Außerdem sollte die Differenz der Redoxpotentiale nicht zu groß sein. Zu große Potentialdifferenzen erhöhen nämlich die Reaktionsfreude der galvanischen Zelle, so dass es zu einer zu schnellen Abgabe von Silber-Ionen kommen könnte, die für menschliche oder tierische Körper womöglich zu hoch ist. Vorzugsweise ist die Potentialdifferenz kleiner als 500 mV.

In der Figur 6 ist die resultierende Struktur 90 von oben dargestellt. Man erkennt, dass die Nanoteilchen 40 und die Nanoteilchen 70 schachbrettmusterartig angeordnet sind, so dass zu jedem Nanoteilchen einer Art jeweils vier benachbarte Partner-Nanoteilchen der jeweils anderen Art vorhanden sind.

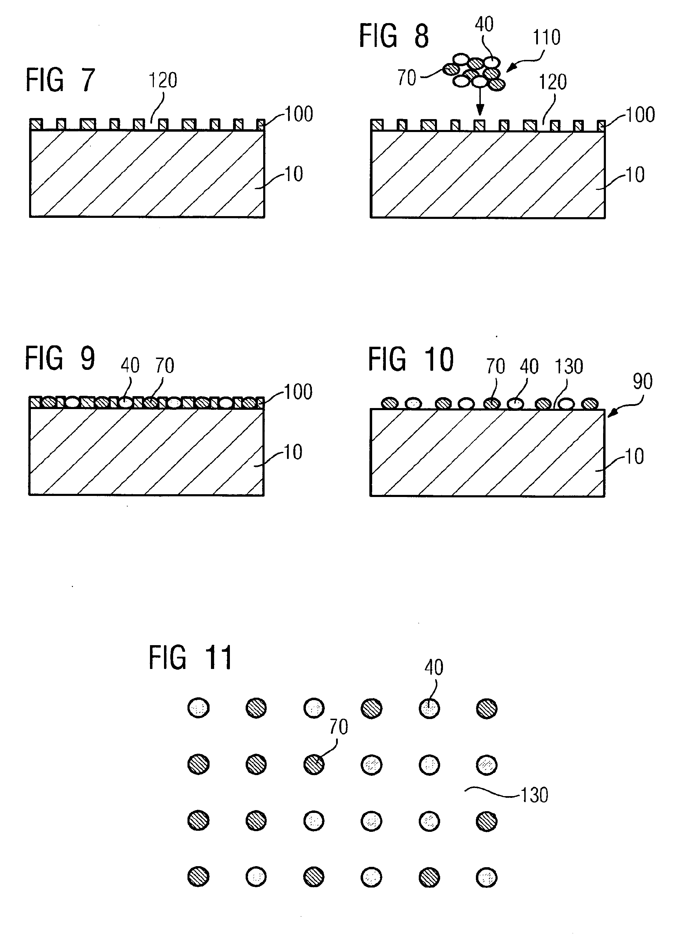

Im Zusammenhang mit den Figuren 7 bis 11 wird nun ein zweites Ausführungsbeispiel zum Herstellen einer Anordnung mit Nanoteilchen erläutert.

In der Figur 7 erkennt man einen Träger 10, auf dem eine Lochmaske 100 aufgebracht ist. Die Lochmaske 100 kann wiederum durch eine entsprechend strukturierte Fotomaske gebildet sein.

Auf dem mit der Lochmaske 100 versehenen Träger 10 wird nun eine Mischung aus fertigen Nanoteilchen 110 aufgetragen. Die Mischung 110 besteht aus Nanoteilchen 40 aus einem ersten Metallmaterial M1 und Nanoteilchen 70 aus einem zweiten Metallmaterial M2. Die Mischung ist derart zusammengesetzt, dass die Anzahl der Nanoteilchen aus dem ersten Metallmaterial M1 ungefähr dem Anteil der Nanoteilchen aus dem zweiten Metallmaterial M2 entspricht.

Die Mischung 110 wird nun auf den Träger 10 mit der Lochmaske 100 gebracht, so dass die Öffnungen bzw. Löcher 120 der Lochmaske 100 mit den Nanoteilchen 40 bzw. 70 gefüllt werden. Die Verteilung der Nanoteilchen 40 bzw. 70 in den Öffnungen 120 ist dabei zufällig und hängt wesentlich von der Zusammensetzung der Mischung 110 zusammen. Die resultierende Struktur nach dem Aufbringen der Mischung 110 ist schematisch in der Figur 9 dargestellt.

In der Figur 10 ist die Anordnung mit dem Träger 10 und den Nanoteilchen 40 und 70 dargestellt, nachdem die Lochmaske 100 entfernt worden ist. Zum Befestigen der Nanoteilchen 40 bzw. 70 auf der Trägeroberfläche 130 des Trägers 10 können die Nanoteilchen mit einem zusätzlichen Fixiermaterial befestigt werden. Ein solches Fixiermaterial ist aus Gründen der Übersicht in der Figur 10 nicht weiter dargestellt.

Die Figur 11 zeigt in einer Sicht von oben die Verteilung der Nanoteilchen 40 und 70 auf der Trägeroberfläche 130 des Trägers 10. Man erkennt, dass im Unterschied zu dem ersten Ausführungsbeispiel gemäß den Figuren 1 bis 6 keine schachbrettmusterartige Verteilung der Nanoteilchen auftritt, sondern eine stochastische Verteilung der Nanoteilchen. Die Verteilung der Nanoteilchen auf der Trägeroberfläche 130 wird durch die stöchiometrische Verteilung bzw. Zusammensetzung der Mischung 110 der Nanoteilchen 40 und 70 bestimmt.

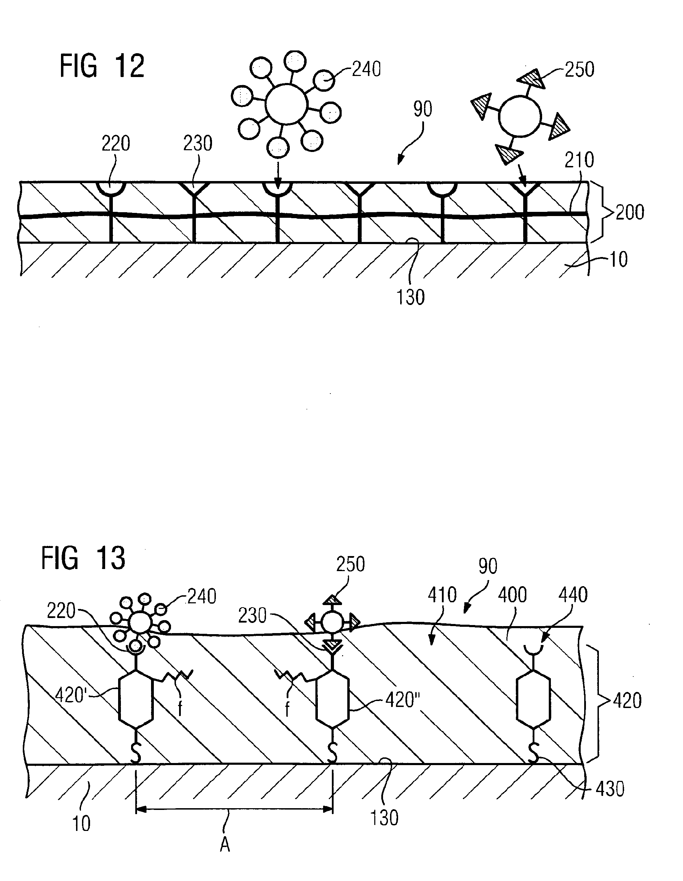

Im Zusammenhang mit der Figur 12 wird nun ein drittes Ausführungsbeispiel für ein Verfahren zum Herstellen einer Anordnung mit einem Träger und Nanoteilchen beschrieben. Man erkennt in der Figur 12 einen Träger 10, auf dem eine Hilfsschicht 200 aufgetragen worden ist. Bei der Hilfsschicht 200 handelt es sich beispielsweise um eine Polymerschicht, die kettenförmige Moleküle 210 aufweist. Die kettenförmigen Moleküle 210 sind längs bzw. parallel zur Trägeroberfläche 130 des Trägers 10 ausgerichtet. Wie sich in der Figur 12 erkennen lässt, sind die kettenförmigen Moleküle 210 mit einer Vielzahl an Koppelstellen 220 und 230 ausgestattet, an denen sich Nanoteilchen ankoppeln können.

Bei dem Ausführungsbeispiel gemäß der Figur 12 wird beispielhaft davon ausgegangen, dass die Ankoppelstellen 220 zum Ankoppeln von Silber-Nanoteilchen 240 geeignet bzw. ausgelegt sind und dass die Ankoppelstellen 230 für ein Ankoppeln von Palladium-Nanoteilchen 250 geeignet bzw. ausgelegt sind. Die entsprechenden Ankoppelmöglichkeiten sind in der Figur 12 schematisch durch die Formgebung der Ankoppelstellen 220 und 230 bzw. durch die Formgebung der entsprechenden Gegenkoppelstellen der Palladium-Nanoteilchen 250 und der Silber-Nanoteilchen 240 dargestellt.

Bei dem dritten Ausführungsbeispiel gemäß der Figur 12 wird davon ausgegangen, dass die Hilfsschicht 200 konkret für ein Ankoppeln von Palladium-Nanoteilchen 250 und Silber-Nanoteilchen 240 geeignet ist; selbstverständlich kann durch eine entsprechende Ausgestaltung der Molekülstruktur der kettenförmigen Moleküle 210 dafür gesorgt werden, dass andere Arten von Nanoteilchen in entsprechender Weise andocken können.

Ein geeignetes Material für die Hilfsschicht 200 ist beispielsweise Cetyltrialkylammonium Bromide.

Nachdem der Träger 10 mit der beschriebenen Hilfsschicht 200 versehen worden ist, wird eine Mischung an fertigen Nanoteilchen 240 und 250 auf die Hilfsschicht 200 aufgetragen. Aufgrund der von der Hilfsschicht 200 bereitgestellten Koppelstellen 220 und 230 werden die Nanoteilchen 240 und 250 entsprechend an die Hilfsschicht 200 ankoppeln, so dass sie in vorbestimmter Weise auf dem Träger 10 anheften. Die Anordnung 90 mit dem Träger 10 und den Nanoteilchen 240 und 250 ist dann fertiggestellt.

Im Zusammenhang mit der Figur 13 wird nun ein viertes Ausführungsbeispiel für ein Verfahren zum Herstellen einer Anordnung 90 mit einem Träger 10 und Nanoteilchen erläutert. Bei diesem Ausführungsbeispiel wird auf der Trägeroberfläche 130 des Trägers 10 eine Hilfsschicht 400 aufgebracht, die aus einem sich vernetzenden Grundmaterial 410 mit darin enthaltenen sich selbst organisierenden Molekülen 420 gebildet ist. Die Hilfsschicht 400 bildet somit selbst eine selbst-organisierende Schicht bzw. einen sogenannten "self-assembling layer".

Die selbst-organisierenden Moleküle 420 sind derart ausgestaltet, dass sie mit einem Molekülende 430 an die Trägeroberfläche 130 des Trägers 10 ankoppeln. Mit einem anderen Molekülende 440 bilden sie eine Koppelstelle, an der Nanoteilchen mit entsprechender Gegenkoppelstelle ankoppeln können. Das in der Figur 13 linke Molekül 420' bildet beispielsweise eine Koppelstelle 220 für die Silber-Nanoteilchen 240 und das in der Figur 13 mittlere Molekül 420" bildet beispielsweise eine Koppelstelle 230 für die Palladium-Nanoteilchen 250.

Die Moleküle 420 weisen darüber hinaus funktionelle Gruppen f auf, die den Abstand A zwischen den Molekülen 420 festlegen. Der Abstand A zwischen den Molekülen 420 definiert damit gleichzeitig den Abstand A, den die Nanoteilchen 240 und 250 auf dem Träger 10 aufweisen werden.

Nach dem Ankoppeln der Nanoteilchen 240 bzw. 250 an den Molekülen 420 und damit auf dem Träger 10 kann das Grundmaterial 410 entfernt werden, so dass nun nur noch die Moleküle 420 sowie die Nanoteilchen 240 bzw. 250 auf dem Träger 10 vorhanden sind.

Ein geeignetes Material für die Hilfsschicht 400 ist beispielsweise Material mit oligomeren Ketten bestehend aus polythiophene-Derivaten.

## Patentansprüche

1. Anordnung (90) mit einem Träger (10) und darauf befindlichen Nanoteilchen (40, 70),
- wobei auf einer Trägeroberfläche (130) des Trägers (10) beabstandet zueinander zwei Arten von Nanoteilchen (40, 70) angeordnet sind, die jeweils beide aus einem Metallmaterial (M1, M2) bestehen und die sich bezüglich des Metallmaterials unterscheiden,
- wobei die beiden Metallmaterialien unterschiedlich edel sind,
**dadurch gekennzeichnet, dass**
- die Nanoteilchen schachbrettmusterartig derart angeordnet sind, dass jedes Nanoteilchen einer Art von vier Nanoteilchen der jeweils anderen Art umgeben wird und
- der Abstand (A) zwischen den Nanoteilchen 5 µm bis 10 µm beträgt.

2. Anordnung Anspruch 1,
**dadurch gekennzeichnet, dass**
der Träger aus einem elektrisch nicht- leitenden oder einem elektrisch schlechtleitenden Material besteht.

3. Anordnung nach einem der voranstehenden Ansprüche,
**dadurch gekennzeichnet, dass**
das unedlere Metallmaterial Silber ist oder Silber enthält.

4. Anordnung nach einem der voranstehenden Ansprüche,
**dadurch gekennzeichnet, dass**
das edlere Metallmaterial aus Palladium, Platin, Rhodium und/oder Ruthenium besteht oder eines dieser Metalle enthält.

5. Verfahren zum Herstellen einer Nanoteilchen aufweisenden Anordnung,
- wobei auf einer Trägeroberfläche (130) eines Trägers (10) beabstandet zueinander zwei Arten von Nanoteilchen (40, 70) aufgebracht werden, die jeweils beide aus einem Metallmaterial (M1, M2) bestehen und die sich bezüglich des Metallmaterials unterscheiden,
- wobei die beiden Metallmaterialien unterschiedlich edel sind
**dadurch gekennzeichnet, dass**
- neben jedem Nanoteilchen der einen Art jeweils zumindest ein Nanoteilchen der jeweils anderen Art unmittelbar benachbart angeordnet wird und
- der Abstand zwischen jedem Nanoteilchen der einen Art und dem unmittelbar benachbarten Nanoteilchen der jeweils anderen Art zwischen 5 µm bis 10 µm beträgt.

6. Verfahren nach Anspruch 5,
**dadurch gekennzeichnet, dass**
der Abstand (A) zwischen den beiden Nanoteilchen derart eingestellt wird, dass die beiden Nanoteilchen in einem Elektrolyten eine galvanische Zelle bilden.

7. Verfahren nach einem der voranstehenden Ansprüche 5-6,
**dadurch gekennzeichnet, dass**
für den Träger ein elektrisch nichtleitendes oder ein elektrisch schlechtleitendes Material gewählt wird.

8. Verfahren nach einem der voranstehenden Ansprüche 5-7,
**dadurch gekennzeichnet, dass**
das unedlere Metallmaterial Silber ist oder Silber enthält.

9. Verfahren nach einem der voranstehenden Ansprüche 5-8,
**dadurch gekennzeichnet, dass**
das edlere Metallmaterial aus Palladium, Platin, Rhodium und/oder Ruthenium besteht oder eines dieser Metalle enthält.

10. Verfahren nach einem der voranstehenden Ansprüche 5-9, **dadurch gekennzeichnet, dass**
- eine erste Lochmaske (20) mit einer vorgegebenen ersten Lochanordnung (30) auf der Trägeroberfläche (130) des Trägers aufgebracht wird,
- Nanoteilchen (40) aus einem ersten Metallmaterial in den durch die Lochanordnung vorgegebenen Positionen auf der Trägeroberfläche befestigt werden,
- eine zweite Lochmaske (50) mit einer vorgegebenen zweiten Lochanordnung (60) auf der Trägeroberfläche aufgebracht wird und
- Nanoteilchen (70) aus einem zweiten Metallmaterial in den durch die Lochanordnung der zweiten Lochmaske vorgegebenen Positionen auf der Trägeroberfläche befestigt werden.

11. Verfahren nach Anspruch 10,
**dadurch gekennzeichnet, dass**
- die Nanoteilchen aus dem ersten Metallmaterial in den Löchern der ersten Lochmaske gebildet werden, indem das erste Metallmaterial (M1) im Bereich der Löcher auf der Trägeroberfläche abgeschieden wird, und/oder
- die Nanoteilchen aus dem zweiten Metallmaterial (M2) in den Löchern der zweiten Lochmaske gebildet werden, indem das zweite Metallmaterial im Bereich der Löcher auf der Trägeroberfläche abgeschieden wird.

12. Verfahren nach Anspruch 10,
**dadurch gekennzeichnet, dass**
- fertige Nanoteilchen aus dem ersten Metallmaterial in die Löcher der ersten Lochmaske eingeführt und auf der Trägeroberfläche befestigt werden und/oder
- fertige Nanoteilchen aus dem zweiten Metallmaterial in die Löcher der zweiten Lochmaske eingeführt und auf der Trägeroberfläche befestigt werden.

13. Verfahren nach Anspruch 5-9,
**dadurch gekennzeichnet, dass**
- auf der Trägeroberfläche (130) eine Hilfsschicht (200, 400) aufgebracht wird, die für jede der zwei Arten von Nanoteilchen jeweils chemische Ankoppelstellen (220, 230) bereitstellt, an denen die Nanoteilchen chemisch ankoppeln können, wobei die Ankoppelstellen beabstandet zueinander sind, und
- eine Mischung (110) aus fertigen Nanoteilchen aus zumindest zwei unterschiedlich edlen Metallmaterialien (M1, M2) auf der mit der Hilfsschicht versehenen Trägeroberfläche aufgebracht wird und eine durch die Anordnung der Koppelstellen auf der Hilfsschicht vorgegebene Nanoteilchenverteilung auf dem Träger erreicht wird.

14. Verfahren nach Anspruch 13,
**dadurch gekennzeichnet, dass**
die Hilfsschicht (200) gebildet wird, indem auf der Trägeroberfläche eine Polymerschicht (200) mit einer Molekülstruktur (210) aufgetragen wird, die für jede der zwei Arten von Nanoteilchen jeweils zumindest eine Ankoppelstelle bereitstellt.

15. Verfahren nach Anspruch 13,
**dadurch gekennzeichnet, dass**
die Hilfsschicht (400) gebildet wird, indem auf der Trägeroberfläche ein sich vernetzendes Material (410) mit selbst organisierenden Molekülen (420) aufgebracht wird, die jeweils zumindest eine Ankoppelstelle (220,230) bereitstellen.

16. Verfahren nach einem der voranstehenden Ansprüche 5-15,
**dadurch gekennzeichnet, dass**
die Vielzahl an Nanoteilchen schachbrettmusterartig derart angeordnet wird, dass jedes Nanoteilchen einer Art von vier Nanoteilchen der jeweils anderen Art umgeben wird.

17. Verfahren nach Anspruch 5-9,
**dadurch gekennzeichnet, dass**
eine Mischung (110) aus fertigen Nanoteilchen aus zumindest zwei unterschiedlich edlen Metallmaterialien auf einem mit einer Lochmaske (100) versehenen Träger (10) aufgebracht wird.

## Claims

1. Arrangement (90) comprising a support (10) and nanoparticles (40, 70) present thereon,
- where two types of nanoparticles (40, 70) which each comprise a metal material (M1, M2) and differ in respect of the metal material are arranged at a distance from one another on a support surface (130) of the support (10),
- where the two metal materials are noble to a different extent,
- the nanoparticles are arranged in the manner of a chessboard so that each nanoparticle of one type is surrounded by four nanoparticles of the other type and
- the distance (A) between the nanoparticles is from 5 µm to 10 µm.

2. Arrangement according to Claim 1, **characterized in that** the support consists of an electrically nonconductive material or a material which has poor electrical conductivity.

3. Arrangement according to either of the preceding claims, **characterized in that** the less noble metal material is silver or comprises silver.

4. Arrangement according to any of the preceding claims, **characterized in that** the more noble metal material consists of palladium, platinum, rhodium and/or ruthenium or comprises one of these metals.

5. Process for producing an arrangement comprising nanoparticles,
- where two types of nanoparticles (40, 70) which each comprise a metal material (M1, M2) and differ in respect of the metal material are arranged at a distance from one another on a support surface (130) of the support (10),
- where the two metal materials are noble to a different extent,
**characterized in that**
- each nanoparticle of the one type has at least one nanoparticle of the other type arranged directly adjacent to it and
- the distance between each nanoparticle of the one type and the directly adjacent nanoparticle of the other type is in the range from 5 µm to 10 µm.

6. Process according to Claim 5, **characterized in that** the distance (A) between the two nanoparticles is set so that the two nanoparticles form an electrochemical cell in an electrolyte.

7. Process according to either of the preceding Claims 5-6, **characterized in that** an electrically nonconductive material or a material which has poor electrical conductivity is selected for the support.

8. Process according to any of the preceding Claims 5-7, **characterized in that** the less noble metal material is silver or comprises silver.

9. Process according to any of the preceding Claims 5-8, **characterized in that** the more noble metal material consists of palladium, platinum, rhodium and/or ruthenium or comprises one of these metals.

10. Process according to any of the preceding Claims 5-9, **characterized in that**
- a first perforated mask (20) having a predetermined first arrangement of holes (30) is applied to the support surface (130) of the support,
- nanoparticles (40) of a first metal material are affixed to the support surface in the positions determined by the arrangement of holes,
- a second perforated mask (50) having a predetermined second arrangement of holes (60) is applied to the support surface and
- nanoparticles (70) of a second metal material are affixed to the support surface in the positions determined by the arrangement of holes in the second perforated mask.

11. Process according to Claim 10, **characterized in that**
- the nanoparticles of the first metal material are formed in the holes of the first perforated mask by the first metal material (M1) being deposited on the support surface in the region of the holes, and/or
- the nanoparticles of the second metal material (M2) being formed in the holes of the second perforated mask by the second metal material being deposited on the support surface in the region of the holes.

12. Process according to Claim 10, **characterized in that**
- finished nanoparticles of the first metal material are introduced into the holes of the first perforated mask and affixed to the support surface and/or
- finished nanoparticles of the second metal material are introduced into the holes of the second perforated mask and affixed to the support surface.

13. Process according to Claims 5-9, **characterized in that**
- an auxiliary layer (200, 400) which provides chemical coupling positions (220, 230) for each of the two types of nanoparticles, to which the nanoparticles can couple chemically, is applied to the support surface (130), with the coupling positions being located at a distance from one another, and
- a mixture (110) of finished nanoparticles of at least two metal materials (M1, M2) which are noble to a different extent is applied to the support surface provided with the auxiliary layer and a nanoparticle distribution determined by the arrangement of the coupling positions on the auxiliary layer is achieved on the support.

14. Process according to Claim 13, **characterized in that** the auxiliary layer (200) is formed by applying a polymer layer (200) having a molecular structure (210) which provides at least one coupling position for each of the two types of nanoparticles to the support surface.

15. Process according to Claim 13, **characterized in that** the auxiliary layer (400) is formed by applying a crosslinking material (410) comprising self-assembling molecules (420) which each provide at least one coupling position (220, 230) to the support surface.

16. Process according to any of the preceding Claims 5-15, **characterized in that** the plurality of nanoparticles are arranged in the manner of a chessboard so that each nanoparticle of one type is surrounded by four nanoparticles of the other type.

17. Process according to Claims 5-9, **characterized in that** a mixture (110) of finished nanoparticles of at least two metal materials which are noble to a different extent is applied to a support (10) provided with a perforated mask (100).

## Revendications

1. Ensemble ( 90 ) comprenant un support ( 10 ) et des nanoparticules ( 40, 70 ) se trouvant dessus,
- dans lequel sur une surface ( 130 ) de support ( 10 ) sont disposées, à distance l'un de l'autre, deux types de nanoparticules ( 40, 70 ) constitués respectivement tous deux d'un matériau ( M1, M2 ) métallique et qui se distinguent en ce qui concerne le matériau métallique,
- dans lequel les deux matériaux métalliques sont différemment précieux, **caractérisé en ce que**
- les nanoparticules sont disposées suivant un modèle en échiquier de sorte que chaque nanoparticule d'un type soit entourée de quatre nanoparticules de respectivement l'autre type et
- la distance ( A ) entre les nanoparticules va de 5 µm à 10 µm.

2. Agencement suivant la revendication 1,
**caractérisé en ce que**
le support est en un matériau non conducteur de l'électricité ou en un matériau mauvais conducteur de l'électricité.

3. Agencement suivant l'une des revendications précédentes,
**caractérisé en ce que**
le matériau métallique qui n'est pas précieux est de l'argent ou contient de l'argent.

4. Agencement suivant l'une des revendications précédentes,
**caractérisé en ce que**
le matériau précieux est en palladium, en platine, en rhodium et/ou en ruthénium ou contient l'un de ces métaux.

5. Procédé de production d'un agencement comprenant des nanoparticules,
- dans lequel on dépose sur une surface ( 130 ) d'un support ( 10 ) à distance l'un de l'autre deux types de nanoparticules ( 40, 70 ) qui sont constitués respectivement tous deux d'un matériau ( M1, M2 ) métallique et qui se distinguent en ce qui concerne le matériau métallique,
- dans lequel les deux matériaux métalliques sont différemment précieux
**caractérisé en ce que**
- à côté de chaque nanoparticule d'un type on dispose, au voisinage immédiat, respectivement au moins une nanoparticule de respectivement l'autre type et
- la distance entre chaque nanoparticule d'un type et les nanoparticules immédiatement voisines de l'autre type est comprise entre 5 µm et 10 µm.

6. Procédé suivant la revendication 5,
**caractérisé en ce que**
on règle la distance ( A ) entre les deux nanoparticules de manière à ce que les deux nanoparticules forment une pile galvanique dans un électrolyte.

7. Procédé suivant l'une des revendications précédentes 5 ou 6,
**caractérisé en ce que**
l'on choisit pour le support un matériau non conducteur de l'électricité ou mauvais conducteur de l'électricité.

8. Procédé suivant l'une des revendications précédentes 5 à 7,
**caractérisé en ce que**
le matériau métallique qui n'est pas précieux est de l'argent ou contient de l'argent.

9. Procédé suivant l'une des revendications précédentes 5 à 8,
**caractérisé en ce que**
le matériau précieux est en palladium, en platine, en rhodium et/ou en ruthénium ou contient l'un de ces métaux.

10. Procédé suivant l'une des revendications précédentes 5 à 9,
**caractérisé en ce que**
- on dépose d'un premier masque ( 20 ) à trous ayant un premier agencement ( 30 ) de trous prescrits sur la surface ( 130 ) du support,
- on fixe sur la surface du support des nanoparticules ( 40 ) en un premier matériau métallique en les positions prescrites par l'agencement de trous,
- on dépose sur la surface du support un deuxième masque ( 50 ) à trous ayant un deuxième agencement ( 60 ) de trous prescrits et
- on fixe sur la surface du support des nanoparticules ( 70 ) en un deuxième matériau métallique dans les positions prescrites par l'agencement de trous du deuxième masque à trous.

11. Procédé suivant la revendication 10,
**caractérisé en ce que**
- on forme les nanoparticules en le premier matériau métallique dans les trous du premier masque à trous à déposant le premier matériau ( M1 ) métallique sur la surface du support dans la région des trous et/ou
- on forme les nanoparticules en le deuxième matériau ( M2 ) métallique dans les trous du deuxième masque à trous en déposant le deuxième matériau métallique sur la surface des supports dans la région des trous.

12. Procédé suivant la revendication 10,
**caractérisé en ce que**
- on introduit des nanoparticules finies en le premier matériau métallique dans les trous du premier masque à trous et on les fixe sur la surface du support et/ou
- on introduit des nanoparticules finies en le deuxième matériau métallique dans les trous du deuxième masque à trous et on les fixe sur la surface du support.

13. Procédé suivant la revendication 5 à 9,
**caractérisé en ce que**
- on dépose sur la surface ( 130 ) du support une couche ( 200, 400 ) auxiliaire qui procure pour chacun deux types de nanoparticules respectivement des points ( 220, 230 ) de liaison chimique où les nanoparticules peuvent se lier chimiquement, les points de liaison étant à distance les uns des autres, et
- on dépose un mélange ( 110 ) de nanoparticules finies en au moins deux matériaux ( M1, M2 ) métalliques différemment précieux sur la surface du support munie de la couche auxiliaire et on obtient sur le support une répartition de nanoparticules prescrites par l'agencement des points de liaison sur la couche auxiliaire.

14. Procédé suivant la revendication 13, **caractérisé en ce que** on forme la couche ( 200 ) auxiliaire en déposant sur la surface du support une couche ( 200 ) de polymère ayant une structure ( 210 ) moléculaire qui procure respectivement au moins un point de liaison pour chacun des deux types de nanoparticules.

15. Procédé suivant la revendication 13,
**caractérisé en ce que**
on forme la couche ( 400 ) auxiliaire en déposant sur la surface du support un matériau ( 410 ) réticulant et ayant des molécules ( 420 ) qui s'organisent d'elles-même et qui procurent respectivement au moins un point ( 220, 230 ) de liaison.

16. Procédé suivant l'une des revendications 5 à 15,
**caractérisé en ce que**
on dispose la pluralité de nanomarticules suivant un type de modèle en échiquier de manière à ce que chaque nanoparticule d'un type soit entourée de quatre nanoparticules de respectivement l'autre type.

17. Procédé suivant la revendication 5 à 9,
**caractérisé en ce que**
on dépose un mélange ( 110 ) de nanoparticules finies en au moins deux matériaux métalliques précieux différemment sur un support ( 10 ) muni d'un masque ( 100 ) à trous.
